(19) Europäisches Patentamt
European Patent Office
Office européen des brevets

(11) EP 1 303 048 A1

(12) # EUROPEAN PATENT APPLICATION

(43) Date of publication:
**16.04.2003 Bulletin 2003/16**

(51) Int Cl.[7]: **H03M 1/38**

(21) Application number: **02021533.1**

(22) Date of filing: **26.09.2002**

(84) Designated Contracting States:
**AT BE BG CH CY CZ DE DK EE ES FI FR GB GR IE IT LI LU MC NL PT SE SK TR**
Designated Extension States:
**AL LT LV MK RO SI**

(30) Priority: **28.09.2001 IN DE10052001**

(71) Applicant: **STMicroelectronics Pvt. Ltd**
**Noida-201 3001, Uttar Pradesh (IN)**

(72) Inventor: **Nandy, Tapas**
**Dehli-110091 (IN)**

(74) Representative: **Botti, Mario**
**Botti & Ferrari S.r.l.,**
**Via Locatelli, 5**
**20124 Milano (IT)**

(54) **An improved switched-capacitor based charge redistribution successive approximation analog to digital converter (ADC)**

(57) This invention relates to an improved binary-weighted, switched-capacitor, charge-redistribution successive approximation Analog-to-Digital Converter (ADC) characterized in that it includes an adjusting mechanism for adding a charge corresponding to one-half of the Least Significant Bit (LSB) of said ADC to the charge stored in the switched capacitor array after the sampling phase of said ADC so as to provide a quantization error that is evenly distributed between +0.5 LSB and -0.5 LSB, without the need for any additional processing clock cycles.

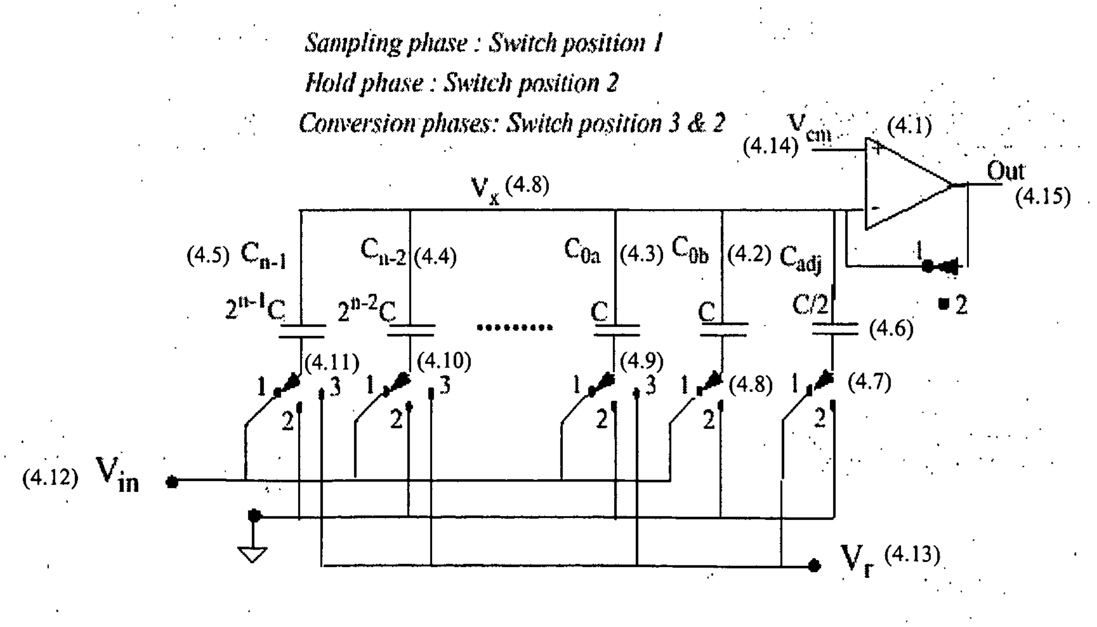


Figure 4

EP 1 303 048 A1

## Description

### Field of the invention

This invention relates to an improved switched-capacitor based charge redistribution successive approximation analog to Digital Converter (ADC) that provides a quantization error that is evenly distributed between +0.5 lsb and -0.5 lsb.

### Background of the invention

Analog to Digital Converters (ADCs) are used to convert analog signals to digital form. The resolution of the conversion determined by the number of bits provided in the digital output of the ADC and the accuracy is defined by its deviation from the true value of the analog input signals.

Figure 1(a) shows an ideal ADC transfer characteristic, in which straight line (1.1) corresponds to analog input or an ideal, infinite resolution ADC while the staircase waveform (1.2) is the output of an ideal finite resolution ADC. The deviation of the stepped waveform (1.2) from the analog input is the quantization error of the ADC and is shown in Figure 1(b) to be varying between +0.5 lsb (Least Signification Bit value) and -0.5 lsb (1.3).

Figure 2(a) and 2(b) show the transfer characteristic and quantization error respectively of a switched-capacitor charge redistribution successive approximation ADC according to the present state-of-art. It is seen that the transfer characteristic (2.2) is shifted with respect to the true value (2.1) resulting in a quantization error (2.3) that varies between 0 lsb and -1.0 lsb. This unsymmetrical error distribution is undesirable as it reduced the error margins for other components thereby resulting in increased effective error.

Previous inventions have addressed the overall error correction problem. US patent 4,399,426 describes a Self-calibrating Successive Approximation Register ADC using redundant switched-capacitor arrays and successive approximation registers and logic together with a memory containing correction data that is added to the normal output in order to compensate for the error. This technique is designed to adjust for individual capacitor mismatches in the binary-weighted switched capacitor network and does not really address the unsymmetrical quantization error problem. The technique is expensive in terms of circuit size and conversion time.

US patent 4,451,821, US Patent 4,999,633 and US patent 5,684,487 similarly address the errors arising from individual capacitor value deviations in the switched-capacitor network. These inventions also do not address the unsymmetrical quantization error issue.

US Patent 4,975,700 provides a solution for correcting linear and quadratic error terms arising from capacitor value dependence an applied voltage. It does not address unsymmetrical quantization error issues.

US patent 5,852,415 addresses the problem of correcting for gain and input offset errors including quantization error misalignment. However, the technique used requires a trimmable capacitor array, array switches, a digital controller and additional calibration steps that result in significant overhead in circuit size and conversion time, on top of a separate calibration phase.

### Summary Of The Invention

The object of this invention is to provide an improved switched capacitor, charge redistribution successive approximation register analog-to-digital converter with a quantization error that is evenly distributed between +0.5 lsb and -0.5 lsb, without significant increase in size and with no increase in conversion time.

To achieve the said objective, this invention provides an improved binary-weighted, switched-capacitor, charge-redistribution successive approximation Analog-to-Digital Converter (ADC) characterized in that it includes an adjusting mechanism for adding a charge corresponding to one-half of the Least Significant Bit (LSB) of said ADC to the charge stored in the switched capacitor array during the sampling phase of said ADC so as to provide a quantization error that is evenly distributed between +0.5 LSB and -0.5 LSB, without the need for any additional processing clock cycles.

The said adjusting mechanism comprises an adjusting capacitor with a value equal to one-half of the LSB capacitor in said binary weighted switched capacitor array connected at one end to the common terminal of said capacitor array and at the other end to a connection means that connects it to a higher reference voltage during the sampling phase and to a lower reference voltage during the hold phase and conversion phase, the difference between said higher reference voltage and said lower reference voltage being such that the charge injected by said adjusting capacitor after the sampling phase corresponds to one-half of the LSB value of said ADC.

The said ADC using said switched-capacitor network for generating all output bits, wherein said higher reference voltage is the higher reference voltage applied to the capacitors in said switched-capacitor network during the conversion phase and said lower reference voltage is the lower reference voltage applied to said capacitors in switched-capacitor network in the conversion phase.

The said ADC using said switched capacitor network for generating the more significant outputs bits and using a multi-tap resistor divider network for generating the lesser significant output bits, wherein said higher reference voltage and said lower reference voltage are selected from the voltages available from said multi-tap resistor divider network such that the voltage difference along with said adjusting capacitor adds a charge to said switched capacitor array corresponding to one-half of the least significant output bit of said ADC.

The above-improved Analog-to-Digital Converter (ADC) is implemented in a single integrated circuit wherein addition of said adjusting capacitor and said connecting means, results in minimal increase in chip area.

The said connection means is a two-way switch.

The said lower reference voltage is ground for the case of a unipolar supply ADC.

The said lower reference voltage is a negative reference voltage for the case of bipolar supply ADC.

Brief Description Of The Drawings

The invention will now be described with reference to and as illustrated in the accompanying drawings.

Figure 1(a) shows the Ideal ADC transfer characteristic.

Figure 1(b) shows the Ideal ADC quantization error.

Figure 2(a) shows the transfer characteristic of a switched-capacitor successive approximation ADC according to the prior art.

Figure 2(b) shows quantization error of a switched-capacitor, successive approximation ADC according to the prior art.

Figure 3 shows the circuit diagram of a switched-capacitor successive approximation ADC according to the prior art.

Figure 4 shows the circuit diagram of a switched-capacitor successive approximation ADC according to this invention.

Figure 5 shows the circuit diagram of a hybrid successive approximation ADC that using a switched capacitor network for the more significant bits and multi-tap resistor divider network for the less significant bits, according to this invention.

Detailed Description Of The Preferred Embodiments

Figures 1(a), 1(b), 2(a) & 2(b) have been discussed under the background of the invention.

Figure 3 shows a switched capacitor, successive approximation ADC according to prior art (control logic and successive approximation register are not shown). Such an ADC has a quantization error varying between 0 and -1 lsb in theory, resulting in a transfer characteristic which is offset by -0.5 lsb from the ideal ADC characteristic.

The binary weighted capacitors are $C_{n-1}$ (3.5) through $C_{0b}$ (3.2) with unit capacitor value C. The numbers associated with switch positions (3.6 through 3.9) show different phases of conversion process. The analysis is in reference to single supply voltage and single reference voltage ($V_r$) ADC, but is equally applicable to dual supply, dual reference voltage circuits also. $V_{cm}$ (3.11) is usually set to half of $V_r$ or half the supply. $V_{off}$ is the offset voltage of the comparator and stored at the top plate of the capacitor bank during the sampling phase. The converted digital outputs are coded as $b_i$ (i=n-1 to 0).

During sampling phase (switch position 1), the voltage and the charge at the top plate of the capacitor bank are given by

$$V_x = V_{cm} + V_{off} \quad (1)$$

$$Q_x = -(V_{in} - V_{cm} - V_{off}) \cdot 2^n C \quad (2)$$

During hold phase (switch position 2), the top plate voltage is given by the charge (which does not escape

as top plate switch opens prior to hold phase) divided by the total bank capacitors ($2^n$ .C):

$$V_x = -(V_{in} - V_{cm} - V_{off}) \qquad (3)$$

During conversion phase, the bottom plate switches of $C_{n-1}$ (3.5) (for MSB, $b_{n-1}$) through $C_{0a}$ (3.3) (for LSB, $b_0$ ), are thrown back and forth between position 3 ($V_r$) and position 2 (ground) successively, starting from the MSB; $C_{0b}$ (3.2) remains in position 2. $V_x$ (3.12) gets modulated as per the following equation:

$$V_x = (V_{cm} + V_{off}) - V_{in} + V_r \cdot \left[ \sum_{i=n-1}^{0} \frac{b_i}{2^{n-i}} \right] \quad \text{.............} (4)$$

The third term in the right hand side of the equation (4) gives $V_{out}$, the voltage equivalent of converted digital code. If the comparator output is $1_b$ (subscript b stands for binary notation), $V_{in}$ is more than $V_{out}$, So, $b_i$ is set to $1_b$ and the concerned switch is kept at $V_r$. On the other hand, if the comparator output is $0_b$, $b_i$ is reset and the concerned switch is returned to ground.

Now, assume $V_{in}$ (3.14) is around 1 lsb, i.e., $V_r/2^n$, then all conversion phases for higher order bits, $b_{n-1}$ to $b_1$, are reset to $0_b$, $b_0$ is evaluated, by temporarily setting it to $1_b$ and connecting $C_{0a}$'s bottom plate to $V_r$. The last two terms of the right hand side of the equation (4).

$$(4), \left( -V_{in} + V_r \cdot \left[ \frac{b_0}{2^n} \right] \right)$$

is positive as long as $V_{in}$ is less than 1 lsb, and $V_x$ is more than $V_{cm}$ + $V_{off}$ , hence the comparator output is $0_b$ and $b_0$ is reset. So, digital output is $00..0_b$, equivalent to $V_{out}$ = 0, digital output becomes $00..1_b$ only when $V_{in}$ > 1 lsb. Similarly, it can be shown, that digital output increments only when $V_{in}$ is greater than 1 lsb, 2 lsb, 3 lsb etc. and the quantization noise varies from 0 to -1 lsb, as shown in figure 2(b).

Figure 4 shows the improved switched-capacitor ADC. An extra capacitor $C_{adj}$ (of value C/2) (4.6) is added to the bank of capacitor, so the total capacitance of the bank becomes ($2^n$ + ½) · C.

During sampling phase (switch position 1), bottom plate of $C_{adj}$ (4.6) is connected to $V_r$ (4.13), and during hold and conversion phases its bottom plate is held at ground. The top plate charge of the capacitor bank during sampling phase is:

$$Q_x = -(V_{in}-V_{cm}-v_{off}) \cdot 2^n \cdot C-(V_r-V_{cm}-v_{off}) \cdot \frac{C}{2} \qquad (5)$$

and the top plate voltage during hold phase is:

$$V_x = -(V_{in} - V_{cm} - v_{off}) \cdot \frac{2^n}{\left(2^n + \frac{1}{2}\right)} - (V_r - V_{cm} - v_{off}) \cdot \frac{1/2}{\left(2^n \div \frac{1}{2}\right)} \quad \text{..................} (6)$$

Similarly, during conversion phase, the top plate voltage gets modulated (bottom plate switches of $C_{n-1}$ (4.5) through $C_{0a}$ (4.3) switches between position 3 and 2, and those of $C_{0b}$ (4.2) & $C_{adj}$ (4.6) remain in position 2) as:

$$V_x = -(V_{in} - V_{cm} - v_{off}) \cdot \frac{2^n}{\left(2^n + \frac{1}{2}\right)} - (V_r - V_{cm} - v_{off}) \cdot \frac{1/2}{\left(2^n + \frac{1}{2}\right)}$$

$$+ V_r \cdot \frac{2^n}{\left(2^n + \frac{1}{2}\right)} \cdot \left[\sum_{i=n-1}^{0} \frac{b_i}{2^{n-i}}\right]$$

$$= (V_{cm} + V_{off}) - \left(V_{in} \cdot \frac{2^n}{\left(2^n + \frac{1}{2}\right)}\right) - \left(V_r \cdot \frac{1/2}{\left(2^n + \frac{1}{2}\right)}\right)$$

$$+ V_r \cdot \frac{2^n}{\left(2^n + \frac{1}{2}\right)} \cdot \left[\sum_{i=n-1}^{0} \frac{b_i}{2^{n-i}}\right] \text{..........................} (7)$$

By similar treatment, as in the previous section, we investigate, when $V_{in}$ (4.12) is around 0.5 lsb, i.e., ½ . $V_r/2^n$, $b_{n-1}$ through $b_1$ are reset to $0_b$ and $b_0$ is evaluated by temporarily setting it to $1_b$ and connecting bottom plate of $C_{0a}$ (in figure 4) to $V_r$. Last three terms of equation

(7) become $$-V_r \cdot \frac{1/2}{\left(2^n + \frac{1}{2}\right)} - V_r \cdot \frac{1/2}{\left(2^n + \frac{1}{2}\right)} + V_r \cdot \frac{1}{\left(2^n + \frac{1}{2}\right)}$$

and is negative the moment $V_{in}$ is more than 0.5 lsb. Hence, $V_x$ (4.8) becomes less than ($V_{cm}$ + $V_{off}$) and comparator output becomes $1_b$, $b_0$ is set to $1_b$, $D_{out}$ = $00..1_b$ and remain in this state till $V_{in}$<1.5 lsb. This analysis can be extended to other bits' evaluation and found that digital output increments at 0.5, 1.5, 2.5 lsb etc. of $V_{in}$. Now, it is clear that $V_{out}$ - $V_{in}$ , the quantization error, vary between -0.5 to +0.5 lsb, as in the case of ideal ADC , as in figure 1(b).

Figure 5 shows the application of the improvement technique to an ADC using a hybrid of switched-capacitor and multi-tap resistor divider network, where lower k-bits of an M-bit ADC are determined by the resistive divider chain. Here, M=n+k. In this case, the 3rd term of equation (7),

$$\left(V_r \cdot \frac{½}{\left(2^n + ½\right)}\right)$$

does not represent a half-lsb addition to $V_{in}$. During sampling (switch position 1), bottom plate of the $C_{adj}$ (5.11) is connected to the upper tap-point (5.12) of any resistor segment, $R_x$, in the resistor divider chain. After sampling, during hold and conversion phase (switch position 2), $C_{adj}$'s bottom plate is connected lower tap-point (5.13) of the same resistor, $R_x$. The voltage difference at these two tap-points is $V_r/2^k$ and the 3rd term of equation (7) gets modified to

$$\left(\frac{V_r}{2^k} \cdot \frac{½}{\left(2^n + ½\right)}\right),$$

and value is equivalent to half lsb of M (=n+k) bit conversion; this value gets added to $V_{in}$. Hence, the ADC's transfer curve gets aligned to the ideal characteristic, in this case also.

***Advantages:***

*(i)* This technique provides the designer with +0.5 to -0.5 lsb of margin for the circuit component inaccuracies, in case the designer wants a ±1lsb error margin in the ADC design. For example, if it is assumed that, the matching accuracy of the binary weighted capacitors are perfect, comparator resolution can be relaxed to 0.5 lsb.

Alternatively, if comparator is assumed perfect, $C_{n-1}$ capacitor can have a mismatch of $100/2^{n-1}$ % from the rest of the bank and so on; A practical choice, would be a mix of both the advantages.

*(ii)* There is no extra clock cycle needed during sampling/conversion phase.

*(iii)* The ADC's converted output would have ideally no offset error and saturate at a $V_{in}$, 1.5 lsb below $V_r$, it is same as the ideal case, and this effect is called the adc over-loading.

The reduction in each lsb step, due to scaling down of $V_x$ swing, is $[2^n/(2^n + ½)]$ times less than the circuit without $C_{adj,}$ so the resolution of the comparator has to be better. For a 10 bit ADC, this demand is just 0.05% more compared to not having $C_{adj}$ capacitor.

## Claims

1. An improved binary-weighted, switched-capacitor, charge-redistribution successive approximation Analog-to-Digital Converter (ADC) **characterized in that** it includes an adjusting mechanism for adding a charge corresponding to one-half of the Least Significant Bit (LSB) of said ADC to the charge stored in the switched capacitor array after the sampling phase of said ADC so as to provide a quantization error that is evenly distributed between +0.5 LSB and -0.5 LSB, without the need for any additional processing clock cycles.

2. An improved Analog-to-Digital Converter (ADC) as claimed in claim 1 wherein said adjusting mechanism comprises an adjusting capacitor with a value equal to one-half of the LSB capacitor in said binary weighted switched capacitor array connected at one end to the common terminal of said capacitor array and at the other end to a connection means that connects it to a higher reference voltage during the sampling phase and to a lower reference voltage during the hold phase and conversion phase, the difference between said higher reference voltage and said lower reference voltage being such that the charge injected by said adjusting capacitor onto said binary weighted switched capacitor array after the sampling phase corresponds to one-half of the LSB value of said ADC.

3. An improved Analog-to-Digital Converter (ADC) as claimed in claim 2 said ADC using said switched-capacitor network for generating all output bits, wherein said higher reference voltage is the higher reference voltage applied to the capacitors in said switched-capacitor network during the conversion phase and said lower reference voltage is the lower reference voltage applied to said capacitors in switched-capacitor network in the conversion phase.

4. An improved Analog-to-Digital Converter (ADC) as claimed in claim 2 said ADC using said switched capacitor network for generating the more significant outputs bits and using a multi-tap resistor divider network for generating the lesser significant output bits, wherein said higher reference voltage and said lower reference voltage are selected from the voltages available from said multi-tap resistor divider network such that the voltage difference along with said adjusting capacitor adds a charge to said switched capacitor array corresponding to one-half of the least significant output bit from said ADC.

5. An improved Analog-to-Digital Converter (ADC) as claimed in claim 2 implemented in a single integrated circuit wherein addition of said adjusting capacitor and said connecting means, results in minimal increase in chip area.

6. An improved Analog-to-Digital Converter (ADC) as claimed in claim 2 wherein said connection means is a two-way switch.

7. An improved Analog-to-Digital Converter (ADC) as claimed in claim 2 wherein said lower reference voltage is ground for the case of a unipolar supply ADC.

**8.** An improved Analog-to-Digital Converter (ADC) as claimed in claim 2 wherein said lower reference voltage is a negative reference voltage for the case of bipolar supply ADC.

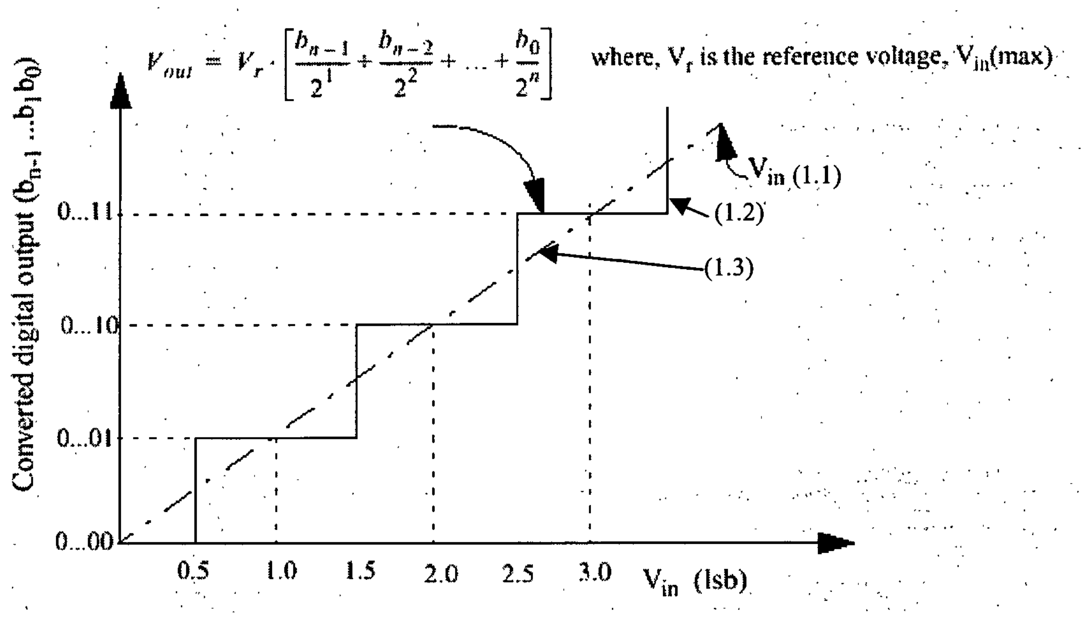


Figure 1(a)

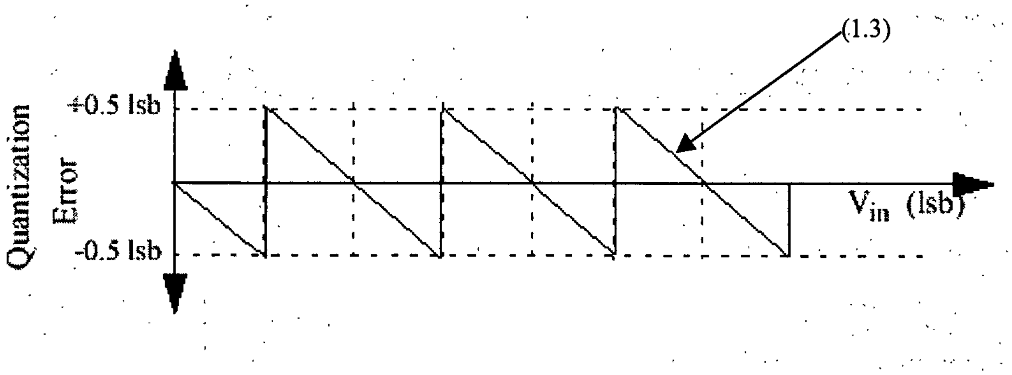


Figure 1(b)

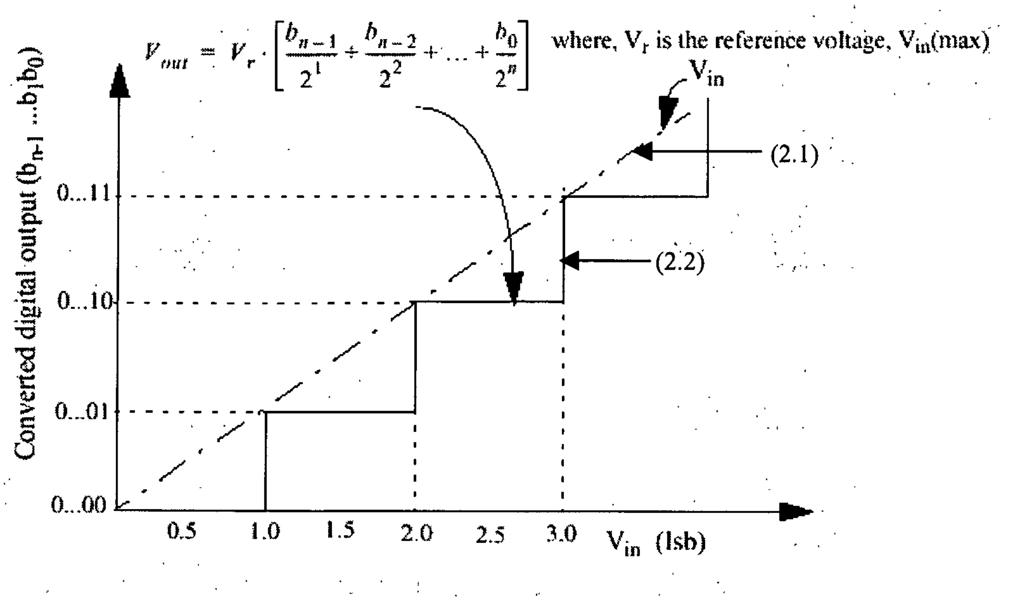


Figure 2(a)

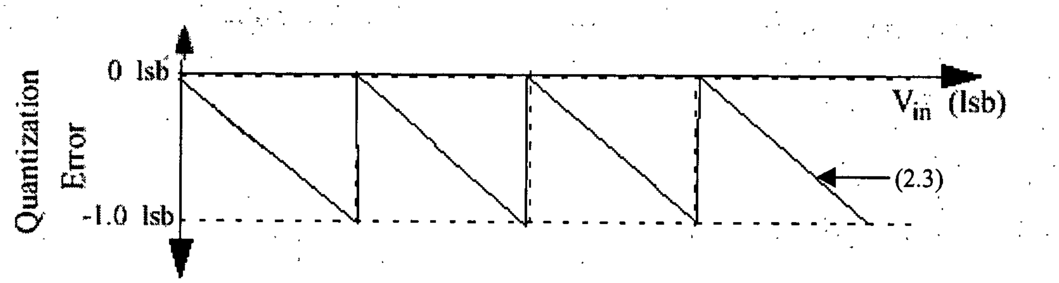


Figure 2(b)

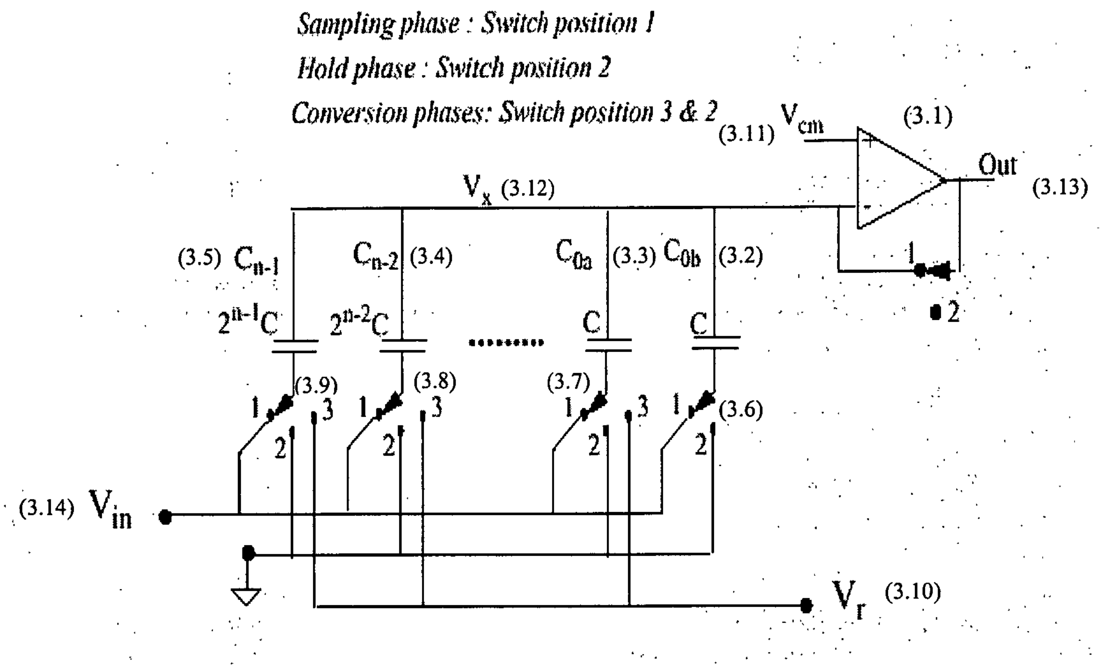


Figure 3

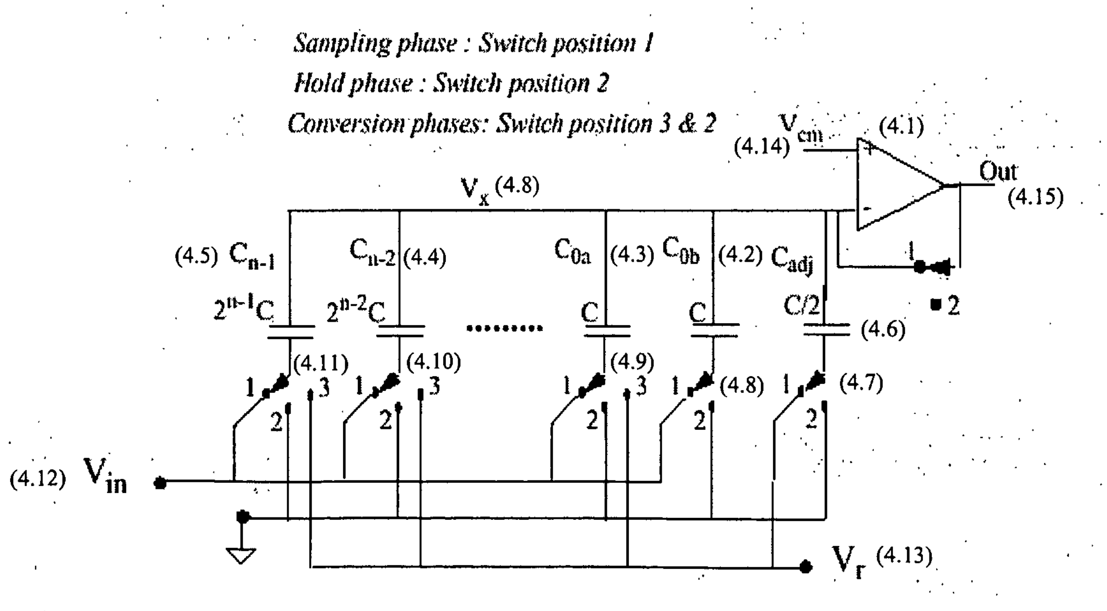


Figure 4

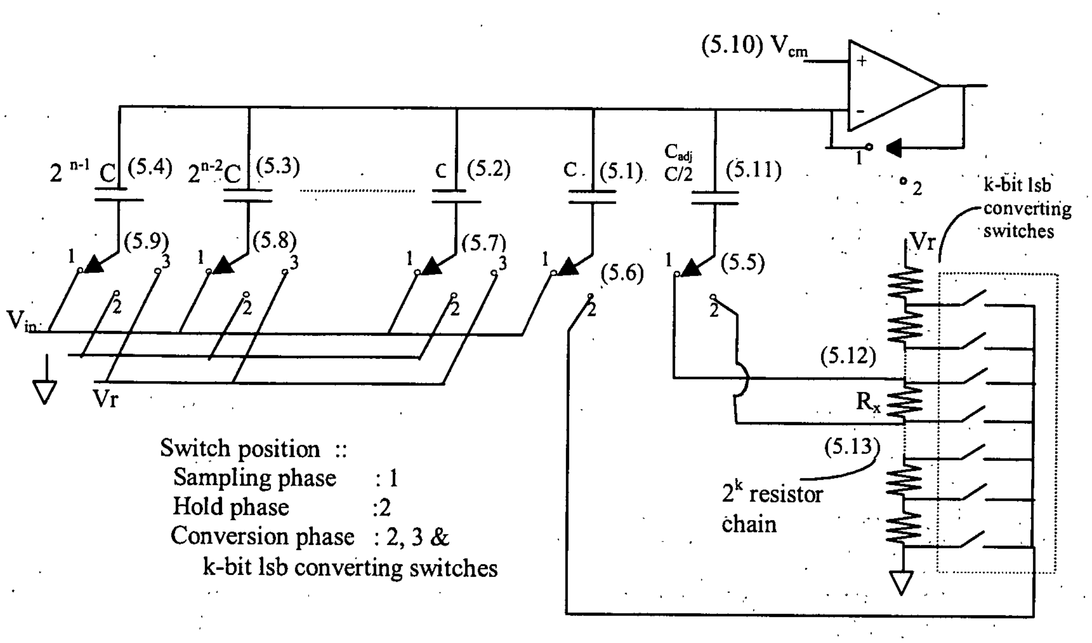
(5.10) $V_{cm}$
+
-
1
2
k-bit lsb
converting
switches
$2^{n-1}$ C
(5.4)
$2^{n-2}$C
(5.3)
C
(5.2)
C
(5.1)
$C_{adj}$
C/2
(5.11)
(5.9)
(5.8)
(5.7)
(5.6)
(5.5)
Vr
$V_{in}$
Vr
(5.12)
$R_x$
(5.13)
$2^k$ resistor
chain
Switch position ::
Sampling phase : 1
Hold phase :2
Conversion phase : 2, 3 &
k-bit lsb converting switches

**Figure 5**

European Patent Office

# EUROPEAN SEARCH REPORT

Application Number
EP 02 02 1533

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 5 258 761 A (FOTOUHI BAHRAM ET AL) 2 November 1993 (1993-11-02) * figure 1 * --- | 1-8 | H03M1/38 |
| X | WONG S ET AL: "AN ANALOG INTERFACE CIRCUIT (AIC) FOR HIGH-SPEED MODEMS" PROCEEDINGS OF THE CUSTOM INTEGRATED CIRCUITS CONFERENCE. NEW YORK, MAY 16 - 19, 1988, NEW YORK, IEEE, US, vol. CONF. 10, 16 May 1988 (1988-05-16), pages 2651-2654, XP000119600 * figures 2,3 * --- | 1-8 | |
| X | US 4 381 496 A (CARTER ERNEST A) 26 April 1983 (1983-04-26) * figures 1B,2 * --- | 1-8 | |
| X | US 4 200 863 A (GRAY PAUL R ET AL) 29 April 1980 (1980-04-29) * figure 1 * --- | 1-8 | TECHNICAL FIELDS SEARCHED (Int.Cl.7) |
| A | US 6 144 331 A (JIANG YI) 7 November 2000 (2000-11-07) * figure 3 * --- | 1-8 | H03M |
| A | PATENT ABSTRACTS OF JAPAN vol. 008, no. 194 (E-264), 6 September 1984 (1984-09-06) & JP 59 083418 A (HITACHI SEISAKUSHO KK), 14 May 1984 (1984-05-14) * abstract; figures 4,5 * --- | 1-8 | |
| | -/-- | | |

The present search report has been drawn up for all claims

| Place of search | Date of completion of the search | Examiner |
|---|---|---|
| MUNICH | 5 February 2003 | Müller, U |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

European Patent Office

# EUROPEAN SEARCH REPORT

Application Number
EP 02 02 1533

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | FOTOUHI B ET AL: "High-resolution A/D conversion in MOS/LSI" IEEE JOURNAL OF SOLID-STATE CIRCUITS, DEC. 1979, USA, vol. SC-14, no. 6, pages 920-926, XP002230095 ISSN: 0018-9200 * figure 2 * ----- | 1-8 | |
| | | | TECHNICAL FIELDS SEARCHED (Int.Cl.7) |

The present search report has been drawn up for all claims

| Place of search | Date of completion of the search | Examiner |
|---|---|---|
| MUNICH | 5 February 2003 | Müller, U |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

## ANNEX TO THE EUROPEAN SEARCH REPORT ON EUROPEAN PATENT APPLICATION NO. EP 02 02 1533

This annex lists the patent family members relating to the patent documents cited in the above-mentioned European search report.
The members are as contained in the European Patent Office EDP file on
The European Patent Office is in no way liable for these particulars which are merely given for the purpose of information.

05-02-2003

| Patent document cited in search report | | Publication date | Patent family member(s) | | Publication date |
|---|---|---|---|---|---|
| US 5258761 | A | 02-11-1993 | WO | 9319534 A1 | 30-09-1993 |
| US 4381496 | A | 26-04-1983 | NONE | | |
| US 4200863 | A | 29-04-1980 | US | 4129863 A | 12-12-1978 |
| US 6144331 | A | 07-11-2000 | NONE | | |
| JP 59083418 | A | 14-05-1984 | NONE | | |

EPO FORM P0459

For more details about this annex : see Official Journal of the European Patent Office, No. 12/82